# EUROPEAN PATENT APPLICATION

(11) **EP 2 760 044 A1**
(43) Date of publication of application: **30.07.2014**
(21) Application number: 14150552.9
(22) Date of filing: 09.01.2014
(51) Int. Cl.: H01L 23/29, H01L 23/31, H01L 23/42, H01L 23/00, H01L 25/10

(54) **Embedded package on package systems**

(30) Priority: 25.01.2013 US 201313750169
(71) Applicant: APPLE INC., Cupertino, CA 95014 (US)
(72) Inventor: Chung, Chih-Ming, Cupertino 95014 (US)
(74) Representative: Lang, Johannes

(57) **Abstract**

In some embodiments, a semiconductor device package assembly may include a substrate. The substrate (110) may include a first surface, a second surface substantially opposite of the first surface, and a first set of electrical conductors (140) coupled to the first surface. The first set of electrical conductors may function to electrically connect the substrate. The second surface may include a die (150) electrically coupled to the second surface. In some embodiments, the semiconductor device package may include an electrically insulating material (160) covering at least a portion of the second surface and the die. The electrically insulating material may include a dielectric polymer. The dielectric polymer may function to inhibit deformation of the package during use. The dielectric polymer may include a coefficient of thermal expansion of between about 5 to about 15 ppm/°C. The dielectric polymer may include a modulus of between about 15 to about 25 Gpa.

## Description

### BACKGROUND

### Technical Field

The present invention relates to semiconductor packaging and methods for packaging semiconductor devices. More particularly, some embodiments disclosed herein relate to a PoP (package-on-package) using electrically insulating material including dielectric polymers.

### Description of the Related Art

Package-on-package ("PoP") technology has become increasingly popular as the demand for lower cost, higher performance, increased integrated circuit density, and increased package density continues in the semiconductor industry. As the push for smaller and smaller packages increases, the integration of die and package (e.g., "pre-stacking" or the integration of system on a chip ("SoC") technology with memory technology) allows for thinner packages. Such pre-stacking has become a critical component for thin and fme pitch PoP packages.

A problem that arises with thin and fine pitch PoP packages is the potential for deformation as the pitch is reduced between terminals (e.g., balls such as solder balls) on either the top package or the bottom package in the PoP package. The deformation problem in the PoP structure may be further increased with the use of thin or coreless substrates in the packages. The top package and the bottom package in a PoP structure may have different warpage behavior because of differences in the materials used and/or differences in their structures. The differences in warpage behavior may be caused by differences in the characteristics of materials used in the packages that cause the packages to expand/contract at different rates.

The differences in warpage behavior between the top and bottom packages may cause yield loss in the solder joints coupling the packages (e.g., the connections between solder balls on the top package and landing pads on the bottom package). A large fraction of PoP structures may be thrown away (rejected) because of stringent warpage specifications placed on the top and bottom packages. The rejected PoP structures contribute to low pre-stack yield, wasted materials, and increased manufacturing costs.

### SUMMARY

In some embodiments, an embedded PoP package including a substrate with a die embedded in the substrate. With the die integrated into the substrate the solder mask (which typically includes a material with a high coefficient of thermal expansion (CTE)) is then eliminated from the process. The die is embedded with a dielectric polymer having a low coefficient of thermal expansion which assists in inhibiting warpage of the package when exposed to heat. Dielectric polymers may include a coefficient of thermal expansion of between about 5 to about 15 ppm/°C. Dielectric polymers may include a modulus of between about 15 to about 25 Gpa. Dielectric polymer and embedding the die in the substrate mean that no mold compound or encapsulation is required. If necessary interconnection terminals or vias may be created using laser drilling or ablation. In some embodiments, a heat spreader may be coupled to the die and substrate for thermal enhancement.

In some embodiments, a semiconductor device package assembly may include a substrate. The substrate may include a first surface, a second surface substantially opposite of the first surface, and a first set of electrical conductors coupled to the first surface. The first set of electrical conductors may function to electrically connect the substrate. The second surface may include a die electrically coupled to the second surface. In some embodiments, the semiconductor device package may include an electrically insulating material covering at least a portion of the second surface and the die. The electrically insulating material may include a dielectric polymer. The dielectric polymer may function to inhibit deformation of the package during use. The dielectric polymer may include a coefficient of thermal expansion of between about 5 to about 15 ppm/°C. The dielectric polymer may include a modulus of between about 15 to about 25 Gpa.

### BRIEF DESCRIPTION OF THE DRAWINGS

The following detailed description makes reference to the accompanying drawings, which are now briefly described.
FIG. 1 depicts an embodiment of a semiconductor device package assembly including a cover. At least some of the electrical conductors are not depicted for the sake of clarity.
FIG. 2 depicts an embodiment of a semiconductor device package assembly including a third set of electrical conductors. At least some of the electrical conductors are not depicted for the sake of clarity.
FIG. 3 depicts an embodiment of flow chart representing a method of forming at least a portion of a semiconductor device package assembly.

Specific embodiments are shown by way of example in the drawings and will be described herein in detail. It should be understood, however, that the drawings and detailed description are not intended to limit the claims to the particular embodiments disclosed, even where only a single embodiment is described with respect to a particular feature. On the contrary, the intention is to cover all modifications, equivalents and alternatives that would be apparent to a person skilled in the art having the benefit of this disclosure. Examples of features provided in the disclosure are intended to be illustrative rather than restrictive unless stated otherwise.

The headings used herein are for organizational purposes only and are not meant to be used to limit the scope of the description. As used throughout this application, the word "may" is used in a permissive sense (i.e., meaning having the potential to), rather than the mandatory sense (i.e., meaning must). The words "include," "including," and "includes" indicate open-ended relationships and therefore mean including, but not limited to. Similarly, the words "have," "having," and "has" also indicated open-ended relationships, and thus mean having, but not limited to. The terms "first," "second," "third," and so forth as used herein are used as labels for nouns that they precede, and do not imply any type of ordering (e.g., spatial, temporal, logical, etc.) unless such an ordering is otherwise explicitly indicated. For example, a "third die electrically connected to the module substrate" does not preclude scenarios in which a "fourth die electrically connected to the module substrate" is connected prior to the third die, unless otherwise specified. Similarly, a "second" feature does not require that a "first" feature be implemented prior to the "second" feature, unless otherwise specified.

Various components may be described as "configured to" perform a task or tasks. In such contexts, "configured to" is a broad recitation generally meaning "having structure that" performs the task or tasks during operation. As such, the component can be configured to perform the task even when the component is not currently performing that task (e.g., a set of electrical conductors may be configured to electrically connect a module to another module, even when the two modules are not connected). In some contexts, "configured to" may be a broad recitation of structure generally meaning "having circuitry that" performs the task or tasks during operation. As such, the component can be configured to perform the task even when the component is not currently on. In general, the circuitry that forms the structure corresponding to "configured to" may include hardware circuits.

Various components may be described as performing a task or tasks, for convenience in the description. Such descriptions should be interpreted as including the phrase "configured to." Reciting a component that is configured to perform one or more tasks is expressly intended not to invoke 35 U.S.C. § 112, paragraph six, interpretation for that component.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of this application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

### DETAILED DESCRIPTION OF EMBODIMENTS

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

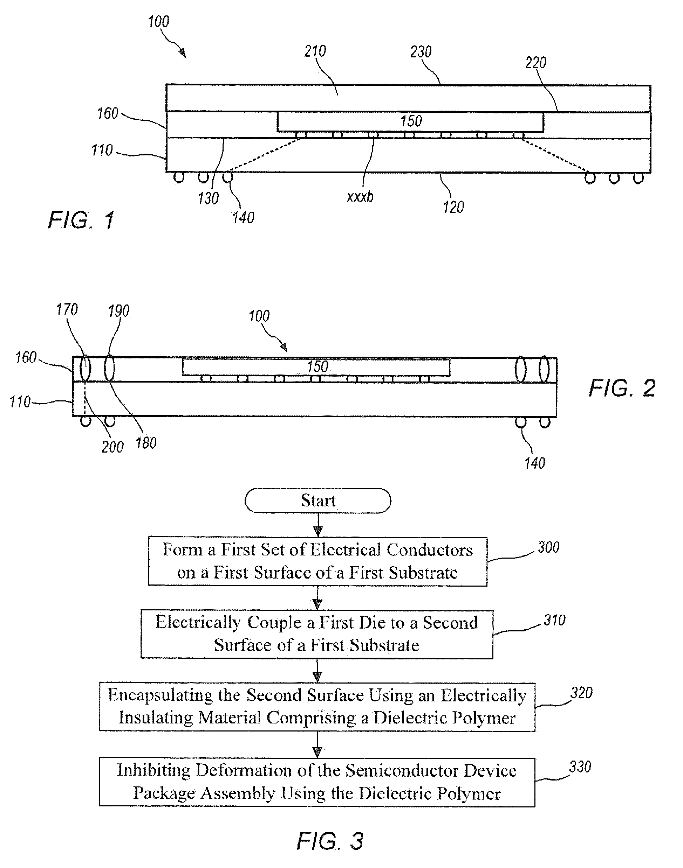

FIG. 1 depicts an embodiment of semiconductor device package assembly 100. At least some of the electrical conductors are not depicted for the sake of clarity. In some embodiments, semiconductor device package assembly 100 may include substrate 110. The substrate may include first surface 120 and second surface 130 substantially opposite of the first surface. The substrate may include first set of electrical conductors 140 coupled to the first surface. The first set of electrical conductors may function to electrically connect the semiconductor device package assembly, and more specifically the substrate, to other electronic devices and/or assemblies. The substrate may include die 150 electrically coupled to the second surface.

In some embodiments, a semiconductor device package assembly may include electrically insulating material 160 covering at least a portion of second surface 130 and die 150. In some embodiments, the electrically insulating material may encapsulate an upper portion of the semiconductor device package assembly. The electrically insulating material may include a dielectric polymer. The dielectric polymer may function to inhibit deformation of the semiconductor device package assembly during use.

Deformation of the semiconductor device package assembly and/or at least a portion of said assembly is commonly referred to as warpage. Excessive warpage may lead to solder ball bridging, solder slumping, head and pillow defects, or open joints. More than 90% of the defects that occur during package-on-package assembly are the result of package warpage. Minimizing warpage is a trade off between materials, temperature control, and time. The extent and degree of warpage is increasing as substrates become thinner. Mismatches in coefficient of thermal expansions between parts of a package assembly may result in increased warpage.

Thermal expansion is the tendency of matter to change in volume in response to change in temperature. The degree of expansion divided by the change in temperature is called the material's coefficient of thermal expansion (CTE) and generally varies with temperature. Reducing the CTE of the various components of a package assembly is generally advantageous in reducing deformation of the package assembly. Substrates have been developed with lower CTEs and as such a dielectric polymer with reduced CTEs would be advantageous. In some embodiments, the dielectric polymer may include a coefficient of thermal expansion of between about 5 to about 15 ppm/°C. Such a CTE may be compared to typical solder masks having a CTE of about 50 to about 60 ppm/°C.

Young's modulus, also known as the tensile modulus, is a measure of the stiffness of an elastic material and is a quantity used to characterize materials. It is defined as the ratio of the uniaxial stress over the uniaxial strain in the range of stress in which Hooke's law holds. The Young's modulus calculates the change in the dimension of a bar made of an isotropic elastic material under tensile or compressive loads. For instance, it predicts how much a material sample extends under tension or shortens under compression. Young's modulus is used in order to predict the deflection that will occur in a statically determinate beam when a load is applied at a point in between the beam's supports. Some calculations also require the use of other material properties, such as the shear modulus, density, or Poisson's ratio. Increasing the modulus of the various components of a package assembly is generally advantageous in reducing deformation of the package assembly when exposed to stress during use. In some embodiments, the dielectric polymer may include a modulus of between about 15 to about 25 Gpa. Such a modulus may be compared to typical solder masks having a modulus of about <5 Gpa.

In some embodiments, the dielectric polymer may include an polymer (e.g., epoxy) based resin and a filler. The dielectric polymer may include an polymer (e.g., epoxy) based resin and a filler, wherein the filler comprises glass fibers.

FIG. 2 depicts an embodiment of a semiconductor device package assembly including a third set of electrical conductors. At least some of the electrical conductors are not depicted for the sake of clarity. In some embodiments, semiconductor device package assembly 100 may include third set of electrical conductors 170 positioned on second surface 130 of first substrate 110. The third set of electrical conductors may include first end 180 coupled to the second surface of the first substrate and second end 190 substantially opposite the first end. The third set of electrical conductors may electrically connect 200, during use, to at least some of the first set of electrical conductors.

In some embodiments, semiconductor device package 100 assembly may include cover 210. The cover may include first side 220 coupled to electrically insulating material 160. The cover may include second side 230 substantially opposite the first side. The cover may function to transfer heat from the first substrate and/or the first die through the cover from the first side to the second side. Effectively the cover may function to dissipate heat generated by the semiconductor device package assembly during use extending life of the package assembly and/or inhibiting deformation of the package assembly.

The cover may function as a heat exchanger that moves heat between a heat source, and a secondary heat exchanger whose surface area and geometry are more favorable than the source. Such a spreader is most often simply a plate made of copper, which has a high thermal conductivity.

Heat spreaders transfer heat from electronic components to passive or active heat sinks. Typically they are used to cool chips in personal computers, laptops, notebooks, cell phones, and other electronic devices. Heat spreaders are used in critical locations for more efficient heat removal. Heat spreaders may be used to reduce electrical component hot spots, such that the component's lifetime is increased and the component's performance is improved.

In some embodiments, the cover may provide structural stability to the package assembly. The cover may be formed from, for example, copper, aluminum alloys, high thermal conductivity ceramics, composite graphite, etc.

FIG. 3 depicts an embodiment of flow chart representing a method of forming at least a portion of a semiconductor device package assembly. In some embodiments, a method for forming a semiconductor device package assembly may include forming a first set of electrical conductors on a first surface of a first substrate 300. The first set of electrical conductors may electrically connect, during use, the semiconductor device package assembly.

In some embodiments, the method may include electrically coupling a first die to a second surface, substantially opposite of the first surface, of the first substrate 310. The first die may be coupled to the second surface using a second set of electrical conductors. The second set of electrical conductors may electrically connect, during use, to at least some of the first set of electrical conductors.

In some embodiments, the method may include encapsulating the second surface of the first substrate and at least a portion of the first die using an electrically insulating material 320. The electrically insulating material may include a dielectric polymer.

In some embodiments, the method may include inhibiting deformation of the semiconductor device package assembly using the dielectric polymer 330.

In some embodiments, the dielectric polymer may be used in place of the solder masking process currently used. In some embodiments, the dielectric polymer may be used in place of the molding or encapsulation process currently used. Replacing one or both of these steps may result in a thinner package assembly reducing the scale such that additional packages may be stacked in a package-on-package assembly. In some embodiments, a package assembly may be about 10 to about 15 microns thick.

In some embodiments, the method may include forming a third set of electrical conductors on the second surface of the first substrate. The third set of electrical conductors may include a first end coupled to the second surface of the first substrate and a second end substantially opposite the first end. The third set of electrical conductors may electrically connect, during use, to at least some of the first set of electrical conductors.

In some embodiments, the method may include exposing at least a portion of the second end of the third set of electrical conductors. For practical reasons it is typically more efficient to The third set of electrical conductors may be exposed by removing any dielectric polymer which has covered the second end of the electrical conductors. At least a portion of the second end of the third set of electrical conductors may be exposed using a laser drill or ablation.

In some embodiments, the method may include coupling a cover to the electrically insulating material. The cover may include a second side substantially opposite the first side. The method may include transferring heat from the first substrate and/or the first die through the cover from the first side to the second side.

Although the embodiments above have been described in considerable detail, numerous variations and modifications will become apparent to those skilled in the art once the above disclosure is fully appreciated. It is intended that the following claims be interpreted to embrace all such variations and modifications.

## Claims

1. A semiconductor device package assembly, comprising:
a substrate including a first surface, a second surface substantially opposite of the first surface, and a first set of electrical conductors coupled to the first surface configured to electrically connect the substrate, wherein the second surface comprises a die electrically coupled to the second surface; and
an electrically insulating material covering at least a portion of the second surface and the die, wherein the electrically insulating material comprises a dielectric polymer, and wherein the dielectric polymer is configured to inhibit deformation of the semiconductor device package assembly during use.

2. The assembly of claim 1, wherein the dielectric polymer is configured to function as a solder mask and/or an encapsulating composition.

3. The assembly of claim 1, further comprising a first side of a cover coupled to the electrically insulating material, wherein the cover comprises a second side substantially opposite the first side, and wherein the cover is configured to transfer heat from the first substrate and/or the first die through the cover from the first side to the second side.

4. The assembly of claim 1, further comprising a third set of electrical conductors positioned on the second surface of the first substrate, wherein the third set of electrical conductors comprise a first end coupled to the second surface of the first substrate and a second end substantially opposite the first end, and wherein the third set of electrical conductors electrically connect, during use, to at least some of the first set of electrical conductors.

5. The assembly of claim 1, wherein the dielectric polymer comprises a coefficient of thermal expansion of between about 5 to about 15 ppm/°C.

6. The assembly of claim 1, wherein the dielectric polymer comprises a modulus of between about 15 to about 25 Gpa.

7. The assembly of claim 1, wherein the dielectric polymer comprises an polymer based resin and a filler.

8. The assembly of claim 1, wherein the dielectric polymer comprises an polymer based resin and a filler, wherein the filler comprises glass fibers.

9. A method for forming a semiconductor device package assembly, comprising:
forming a first set of electrical conductors on a first surface of a first substrate, wherein the first set of electrical conductors electrically connect, during use, the semiconductor device package assembly;
electrically coupling a first die to a second surface, substantially opposite of the first surface, of the first substrate using a second set of electrical conductors, wherein the second set of electrical conductors electrically connect, during use, to at least some of the first set of electrical conductors;
encapsulating the second surface of the first substrate and at least a portion of the first die using an electrically insulating material, wherein the electrically insulating material comprises a dielectric polymer; and
inhibiting deformation of the semiconductor device package assembly using the dielectric polymer.

10. The method of claim 9, further comprising forming a third set of electrical conductors on the second surface of the first substrate, wherein the third set of electrical conductors comprise a first end coupled to the second surface of the first substrate and a second end substantially opposite the first end, and wherein the third set of electrical conductors electrically connect, during use, to at least some of the first set of electrical conductors.

11. The method of claim 10, further comprising exposing at least a portion of the second end of the third set of electrical conductors.

12. The method of claim 10, further comprising exposing at least a portion of the second end of the third set of electrical conductors using a laser drill or ablation.

13. The method of claim 9, further comprising coupling a cover to the electrically insulating material.

14. The method of claim 9, further comprising:
coupling a first side of a cover to the electrically insulating material, wherein the cover comprises a second side substantially opposite the first side; and
transferring heat from the first substrate and/or the first die through the cover from the first side to the second side.

15. The method of claim 9, wherein the dielectric polymer comprises a coefficient of thermal expansion of between about 5 to about 15 ppm/°C.
